(19) Europäisches Patentamt

European Patent Office

Office européen des brevets

(11) **EP 2 511 358 B1**

(12) **EUROPEAN PATENT SPECIFICATION**

(45) Date of publication and mention
of the grant of the patent:
**03.01.2018 Bulletin 2018/01**

(21) Application number: **10835820.1**

(22) Date of filing: **18.11.2010**

(51) Int Cl.:
*C09K 3/14* (2006.01)      *B24B 37/04* (2012.01)
*H01L 21/304* (2006.01)      *C09G 1/02* (2006.01)
*H01L 21/02* (2006.01)      *H01L 29/16* (2006.01)

(86) International application number:
**PCT/JP2010/070549**

(87) International publication number:
**WO 2011/070898 (16.06.2011 Gazette 2011/24)**

(54) **POLISHING SLURRY FOR SILICON CARBIDE AND POLISHING METHOD THEREFOR**

POLIERSCHLAMM FÜR SILICIUMCARBID UND POLIERVERFAHREN DAFÜR

BOUE DE POLISSAGE POUR CARBURE DE SILICIUM ET PROCÉDÉ DE POLISSAGE ASSOCIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **11.12.2009 JP 2009282083**

(43) Date of publication of application:
**17.10.2012 Bulletin 2012/42**

(73) Proprietors:
• **Kyushu University,
National University Corporation
Fukuoka-shi, Fukuoka 812-8581 (JP)**
• **Mitsui Mining and Smelting Co., Ltd.
Shinagawa-ku
Tokyo 141-8584 (JP)**

(72) Inventors:
• **DOI, Toshiro
Fukuoka-shi
Fukuoka 812-8581 (JP)**
• **KUROKAWA, Syuhei
Fukuoka-shi
Fukuoka 812-8581 (JP)**
• **OHNISHI, Osamu
Fukuoka-shi
Fukuoka 812-8581 (JP)**
• **HASEGAWA, Tadashi
Fukuoka-shi
Fukuoka 812-8581 (JP)**

• **KAWASE, Yasuhiro
Tokyo 108-0014 (JP)**
• **YAMAGUCHI, Yasuhide
Tokyo 141-8584 (JP)**

(74) Representative: **Schmitt-Nilson Schraud Waibel
Wohlfrom
Patentanwälte Partnerschaft mbB
Destouchesstraße 68
80796 München (DE)**

(56) References cited:
**EP-A1- 1 717 286      EP-A2- 0 816 457
WO-A1-2007/029465      JP-A- 2001 205 555
JP-A- 2006 041 252      US-A- 6 022 400
US-A- 6 159 858      US-B1- 6 190 443**

• **JUN'ICHI NISHIZAWA ET AL.: 'Cho LSI Gijutsu 22
- Device to Process sono 12' HANDOTAI KENKYU
vol. 44, 1998, pages 245 - 276, XP008155796**
• **MAKOTO SATO ET AL.: 'The trial of polishing of
the single-crystal silicon carbide (SiC) by an
abrasive grain intension polishing pad' ANNUAL
REPORT OF THE CERAMICS RESEARCH
LABORATORY NAGOYA INSTITUTE OF
TECHNOLOGY vol. 7, 2008, pages 49 - 53,
XP008155262**

Remarks:
The file contains technical information submitted after
the application was filed and not included in this
specification

**Description**

BACKGROUND OF THE INVENTION

FIELD OF THE INVENTION

The present invention relates to a technique for polishing silicon carbide, in particular, the use of a polishing slurry for polishing silicon carbide and a polishing method for polishing silicon carbide using as a polishing material manganese dioxide particles.

DESCRIPTION OF THE RELATED ART

Recently, silicon carbide (SiC) and silicon nitride ($Si_3N_4$) have been attracting attention as substrate materials for power electronics semiconductors and white LEDs. These substrate materials are extremely high in hardness, and are known as difficult-to-polish materials. Accordingly, when a substrate for use in epitaxial growth is produced, in general, the surface of the substrate is planarized by performing an abrasive treatment for a long period of time, for the purpose of realizing a high degree of surface precision.

In such an abrasive treatment, for example, silica (see, for example, Patent Document 1) used for polishing silicon semiconductor substrates and diamond fine particles (see, for example, Patent Document 2) higher in hardness than silicon carbide and silicon nitride are used as polishing materials. There have also been proposed polishing methods in which chemical reactions are utilized by irradiating titanium oxide and cerium oxide with light. However, as matters now stand, such conventional polishing treatments take dozens of hours for polishing silicon carbide or silicon nitride because the material hardness of silicon carbide or silicon nitride as an object to be polished is too high.

As a technique for polishing silicon carbide substrates, the use of manganese dioxide ($MnO_2$) as a polishing material has also been known (see, for example, Patent Document 3 and Patent Document 4). In such prior art techniques, for the purpose of taking advantage of dimanganese trioxide, regarded as higher in an abrasive capability than manganese dioxide, dimanganese trioxide is formed on the surface of manganese dioxide particles by calcination or the like of manganese dioxide, and silicon carbide is polished with the thus treated manganese dioxide. According to the abrasive treatment utilizing dimanganese trioxide as in such prior art techniques, silicon carbide can be polished at a comparatively high rate; however, there has been strongly demanded a polishing technique enabling an abrasive treatment at a further higher rate.

US 6159858 discloses a method for polishing semiconductors. The polishing slurry includes Mn02 particles in a solvent in which the pH and the oxidation-reduction potential E are adjusted such that $Mn_2O_3$ covers the surface of the $MnO_2$ particle.

EP 1717286A1 relates to polishing of group III nitride crystal substrates. The polishing method aims at obtaining a smoother surface while maintaining a high polishing rate. The method relies on oxidation and surface etching. Optionally, the polishing liquid may contain abrasive grains, for example manganese dioxide particles. The pH of the polishing liquid may be up to 6 or at least 8.

[Prior Art Documents]

[Patent Documents]

Patent Document 1: Japanese Patent Application Laid-Open No. 2008-166329

Patent Document 2: Japanese Patent Application Laid-Open No. 2009-179726

Patent Document 3: Japanese Patent Application Laid-Open No. Hei 10-72578

Patent Document 4: Japanese Patent Application Laid-Open No. Hei 10-60415

SUMMARY OF THE INVENTION

Problems to be Solved by the Invention

The present invention has been achieved against a background of such circumstances as described above, and an object of the present invention is to provide an abrasive treatment technique capable of planarizing at an extremely high rate silicon carbide, which has a hardness next to that of diamond and is thermally and chemically extremely stable and for which it is extremely difficult to efficiently perform an abrasive treatment.

Means for Solving the Problems

Subject-matter of the invention is the use of a polishing slurry for polishing silicon carbide as claimed in claim 1, and a method for polishing silicon carbide as claimed in claim 2.

The present inventors made a diligent study on the utilization technique of manganese oxide used in an abrasive treatment of silicon carbide. Consequently, the present inventors have thought up the present invention by discovering that polishing of silicon carbide with manganese dioxide particles in manganese oxide dramatically improves the polishing efficiency.

The present invention relates to the use of a polishing slurry for polishing silicon carbide wherein the polishing slurry includes a suspension liquid in which the pH thereof is 6.5 or more and manganese dioxide particles are suspended.

In the polishing slurry for silicon carbide manganese dioxide particles are suspended in an aqueous solution regulated to have a redox potential range allowing manganese to be present as manganese dioxide.

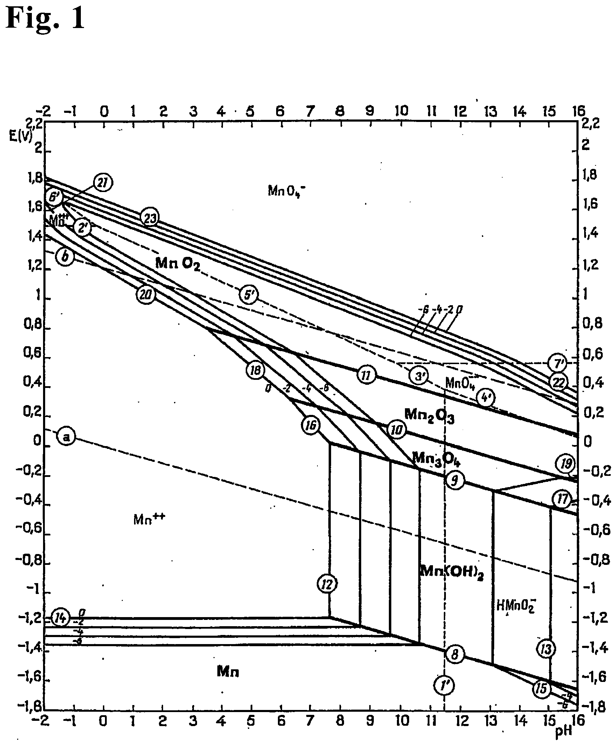

As is known from the phase equilibrium diagram (potential-pH diagram, see Fig. 1) (Atlas of Electrochemical Equilibria in Aqueous Solutions, Marcel Pourbaix, Pergamon Press Cebelcor(1996)) showing the redox reaction of manganese, manganese (Mn) becomes manganese dioxide ($MnO_2$), dimanganese trioxide ($Mn_2O_3$), trimanganese tetraoxide ($Mn_3O_4$) or permanganate ion ($MnO^{4-}$), depending on the pH and the redox potential at the pH. In conventional polishing methods using manganese dioxide, an abrasive treatment has been performed, not under the conditions that manganese dioxide alone is present, but under the conditions that dimanganese trioxide ($Mn_2O_3$) and permanganate ion ($MnO_4^-$) are mixed with manganese dioxide due to calcination, chemical reaction or the like. In particular, in Patent Document 3, silicon carbide is polished under the conditions that the redox potential and the pH are positively regulated so as to allow the formation of dimanganese trioxide ($Mn2O3$). In contrast to this, according to the study of the present inventors, it has been revealed that the efficiency of polishing of silicon carbide is dramatically improved by polishing silicon carbide with a polishing slurry in which intentionally the condition allowing the presence of manganese dioxide is maintained.

The range allowing manganese dioxide to be stably present can be specified on the basis of the phase equilibrium diagram (potential-pH diagram) showing the redox reaction of manganese (Mn). In the present invention, the redox potential value V allowing manganese dioxide to be stably present in a pH range of 6.5 or more satisfies the following formula representing a relation between the redox potential V and pH:

$$1.014\text{-}0.0591 \text{ pH} \leq V \leq 1.620\text{-}0.0743 \text{ pH}$$

In the present invention, the pH within the range in which manganese dioxide can be stably present is specified to be 6.5 or more. According to the study performed by the present inventors, it has been found out that when silicon carbide is polished with manganese dioxide particles, the higher the pH of the polishing slurry is, the more the abrasive capability of the polishing slurry is improved. In the present invention, the pH is 6.5 or more, preferably 8 or more and more preferably 10 or more.

The manganese dioxide in the present invention is not particularly limited with respect to the production method thereof. Manganese dioxide obtained, for example, by the following production methods can be used: a so-called electrolytic method in which manganese dioxide is produced by electrolyzing an electrolyte solution containing manganese (Mn) ion to form oxide on an anode; and a chemical method in which a water-soluble manganese (Mn) salt is neutralized and precipitated with a carbonate or the like, and the precipitate is oxidized. The electrolytic method can be said to be a preferable method because the manganese dioxide produced by the anodic deposition method based on electrolysis is favorably strong with respect to the deposited particles thereof. In the manganese dioxide in the present invention, the average particle size thereof is preferably 0.1 to 1 $\mu$m. This is because when the average particle size exceeds 1 $\mu$m, the polishing material tends to be precipitated to cause the occurrence of the concentration unevenness in the polishing material slurry and the occurrence of polishing failure. The average particle size as referred to herein is determined by a laser diffraction/scattering particle size distribution measurement method, and the average particle size is the particle size $D_{50}$ of the volume-based cumulative fraction of 50% in laser diffraction/scattering particle size distribution measurement.

The polishing slurry for silicon carbide according to the use and the method of the present invention can be realized by suspending in water manganese dioxide having a predetermined average particle size. The suspension liquid in which manganese dioxide is suspended in water (a so-called polishing material slurry or a so-called polishing slurry) can be subjected to a wet pulverization treatment, if necessary. The manganese dioxide concentration in the suspension liquid is preferably set at 1 wt% to 20 wt%. The pH of the suspension liquid can be regulated by adding potassium hydroxide, ammonia, hydrochloric acid or the like. The redox potential can be regulated with hydrogen peroxide water or the like.

Effect of the Invention

As described above, according to the present invention, an abrasive treatment is enabled in which silicon carbide, for which it has been assumed to be extremely difficult to perform an abrasive treatment, is planarized at an extremely high rate.

BRIEF DESCRIPTION OF THE DRAWINGS

[Fig. 1] Fig. 1 is a phase equilibrium diagram (potential-pH diagram) showing the redox reaction of manganese (Mn).
[Fig. 2] Fig. 2 is a microgram of an AFM measurement of the polished surface in Example 1.
[Fig. 3] Fig. 3 is a microgram of an AFM measurement of the polished surface in Comparative Example 3.

MODES FOR CARRYING OUT THE INVENTION

The best mode for carrying out the present invention is described with reference to Examples and Comparative Examples.

Example 1: In Example 1, manganese dioxide was deposited on an anode by electrolysis of an aqueous solution of manganese sulfate. The deposit was collected and disintegrated with a pin mill (Atomizer, manufactured by Powrex Corp.), and then subjected to a dry pulverization treatment with a jet mill (PJM-200SP, manufactured by Nippon Pneumatic Mfg. Co., Ltd.) to yield a manganese dioxide powder having an average particle size of 0.5 $\mu$m. The average particle size was measured with a laser diffraction/scattering particle size distribution analyzer (LA-920, manufactured by Horiba, Ltd.). A manganese dioxide slurry was prepared by dispersing the manganese dioxide powder in purified water so as for the slurry concentration to be 10 wt%. In the manganese dioxide slurry of Example 1, the pH was 6.7 and the redox potential was 0.832 V.

By using the manganese dioxide slurry of Example 1, the following polishing test was performed. As the polishing object, a single crystal substrate of SiC (silicon carbide) of 50.8mm (2 inches) in diameter was used. The polishing method was as follows: a non-woven fabric pad (SUBA-400, manufactured by Nitta Haas Inc.) was bonded to a single surface polisher for CMP (platen diameter: 25 cm, number of rotations: 90 rpm), a load of 18.3 kPa (187gf/cm$^2$) was applied, and polishing was performed for 12 hours. During the 12-hour polishing, polishing was performed while the polishing material slurry was being circulated. The stock removal was calculated by measuring the substrate weights before and after polishing. When the stock removal of Comparative Example 1 shown below was represented by 10 as the reference, the stock removal of Example 1 was five times the stock removal of Comparative Example 1, namely, 50 (See Table 1).

Example 2: A manganese dioxide slurry having a pH of 9.0 and a redox potential of 0.733 V was prepared as follows: the same manganese dioxide powder as in Example 1 was used; the manganese dioxide powder was dispersed in purified water so as for the slurry concentration to be 10 wt %; and potassium hydroxide was added to the slurry to regulate the pH of the slurry. A polishing test was performed under the same conditions as in Example 1, and the stock removal was examined. The result thus obtained is shown in Table 1.

Example 3: A manganese dioxide slurry having a pH of 10.1 and a redox potential of 0.688 V was prepared as follows: the same manganese dioxide powder as in Example 1 was used; the manganese dioxide powder was dispersed in purified water so as for the slurry concentration to be 10 wt %: and potassium hydroxide was added to the slurry to regulate the pH of the slurry. A polishing test was performed under the same conditions as in Example 1, and the stock removal was examined. The result thus obtained is shown in Table 1.

Example 4: A manganese dioxide slurry having a pH of 11.9 and a redox potential of 0.561 V was prepared as follows: the same manganese dioxide powder as in Example 1 was used; the manganese dioxide powder was dispersed in purified water so as for the slurry concentration to be 10 wt %: and potassium hydroxide was added to the slurry to regulate the pH of the slurry. A polishing test was performed under the same conditions as in Example 1, and the stock removal was examined. The result thus obtained is shown in Table 1.

Comparative Example 1: For comparison, the same polishing test as in Example 1 was performed by using a commercially available colloidal silica (Compol 80, average particle size: 70 nm to 80 nm, manufactured by Fujimi Inc.). A colloidal silica slurry was prepared by dispersing the colloidal silica in purified water so as for the slurry concentration to be 10 wt%. A polishing test was performed under the same conditions as in Example 1, and the stock removal was examined. The stock removal of Comparative Example 1 was defined as 10 (unitless), on the basis of which the stock removal values of Examples and Comparative Examples were presented as numerical values. The results thus obtained are shown in Table 1.

Comparative Example 2: In Comparative Example 2, a polishing test was performed by using the manganese dioxide powder (average particle size: 0.5 $\mu$m) of Example 1 calcined at 850°C (1 hour). X-ray diffraction identification of the crystal structure of the manganese dioxide having been calcined verified that the calcination resulted in dimanganese trioxide ($Mn_2O_3$). After calcination, with a bead mill, the calcined product was subjected to a pulverization treatment until the average particle size reached 0.4 $\mu$m. A dimanganese trioxide slurry was prepared by dispersing the thus pulverized dimanganese trioxide powder in purified water so as for the slurry concentration to be 10 wt%. In the dimanganese trioxide slurry of Comparative Example 2, the pH was 5.9 and the redox potential was 0.604 V. By using this slurry, a polishing test was performed under the same conditions as in Example 1, and the stock removal was examined. The result thus obtained is shown in Table 1.

Comparative Example 3: In Comparative Example 3, a manganese dioxide powder (average particle size: 0.5 $\mu$m) obtained in the same manner as in Example 1 was dispersed in water to prepare a slurry. Hydrochloric acid was added to the slurry to regulate the pH of the slurry to be 4.5. The redox potential of the manganese dioxide slurry of Comparative Example 3 was 0.900 V. According to the phase equilibrium diagram (potential-pH diagram) representing the redox reaction of manganese (Mn), shown in Fig. 1, the redox potential and the pH indicate that the particles in the slurry are manganese dioxide particles. The redox potential and the pH of Comparative Example 3 satisfy the formula $1.014 - 0.0591\ pH \leq V \leq 1.620 - 0.0743\ pH$ representing a relation between V and pH; however, the concerned pH value is a value lower than pH 6.5. The result of the polishing test in Comparative Example 3 is shown in Table 1.

[Table 1]

|  | Polishing material | pH | Redox potential (V) | Stock removal |
|---|---|---|---|---|
| Example 1 | $MnO_2$ | 6.7 | 0.832 | 50 |
| Example 2 | $MnO_2$ | 9.0 | 0.733 | 64 |
| Example 3 | $MnO_2$ | 10.1 | 0.688 | 98 |
| Example 4 | $MnO_2$ | 11.9 | 0.561 | 201 |
| Comparative Example 1 | $SiO_2$ | 10.2 | 0.165 | 10 |
| Comparative Example 2 | $Mn_2O_3$ | 5.9 | 0.604 | 10 |
| Comparative Example 3 | $MnO_2$ | 4.5 | 0.900 | 25 |

As shown in Table 1, it has been revealed that in each of Examples, the stock removal for the same period of time is extremely larger as compared to the cases where conventional colloidal silica and the like were used, and the polishing rate is extremely high. It has also been revealed that the larger the pH value of the slurry is, the more the polishing rate is improved. As shown in Comparative Example 3, it has been verified that when the pH falls out of the range of the present invention, the polishing efficiency tends to be degraded.

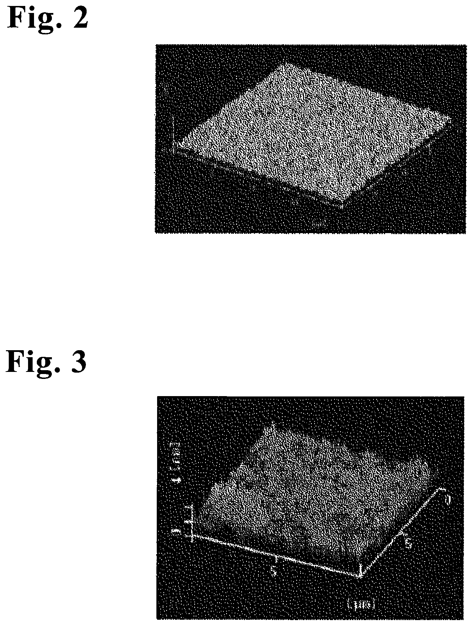

Fig. 2 shows the measurement results of the surface roughness of the polished surface of the substrate after the polishing test in Example 1 with an AFM (atomic force microscope, Nanoscope IIa, manufactured by Veeco Instruments, Inc.). In Example 1, the polished surface was finished extremely flat and smooth, and the surface roughness Ra thereof was 0.281 nm. In contrast to this, it has been verified that the condition of the polished surface in Comparative Example 3 was considerably rough as compared to that in Example 1.

Industrial Applicability

The present invention enables extremely efficient polishing processing of silicon carbide (SiC) used as a substrate material for power electronics semiconductors and white LEDs.

**Claims**

1. Use of a polishing slurry for polishing silicon carbide, the slurry comprising a suspension liquid in which manganese dioxide particles are suspended, wherein the slurry has a pH of 6.5 or more and a redox potential V falling within the range specified by the following formula representing a relation between V and pH: $1.014 - 0.0591\ pH \leq V \leq$

1.620 - 0.0743 pH.

2. A method for polishing silicon carbide, the method comprising using a polishing slurry, the slurry comprising a suspension liquid in which manganese dioxide particles are suspended, wherein the slurry has a pH of 6.5 or more and a redox potential V falling within the range specified by the following formula representing a relation between V and pH: 1.014 - 0.0591 pH $\leq$ V $\leq$ 1.620 - 0.0743 pH.

**Patentansprüche**

1. Verwendung einer Polieraufschlämmung zum Polieren von Siliziumkarbid, wobei die Aufschlämmung eine Suspensionsflüssigkeit aufweist, in der Mangandioxidpartikel suspendiert sind, wobei die Aufschlämmung einen pH-Wert von 6,5 oder mehr sowie ein Redoxpotential V aufweist, das in dem durch die nachfolgende Formel spezifizierten Bereich liegt, die eine Beziehung zwischen V und pH darstellt:

$$1{,}014 - 0{,}0591 \text{ pH} \leq V \leq 1{,}620 - 0{,}0743 \text{ pH}.$$

2. Verfahren zum Polieren von Siliziumkarbid, wobei das Verfahren die Verwendung einer Polieraufschlämmung beinhaltet, wobei die Aufschlämmung eine Suspensionsflüssigkeit aufweist, in der Mangandioxidpartikel suspendiert sind, wobei die Aufschlämmung einen pH-Wert von 6,5 oder mehr sowie ein Redoxpotential V aufweist, das in dem durch die nachfolgende Formel spezifizierten Bereich liegt, die eine Beziehung zwischen V und pH darstellt: 1,014 - 0,0591 pH $\leq$ V $\leq$ 1,620 - 0,0743 pH.

**Revendications**

1. Utilisation d'une boue de polissage pour le polissage de carbure de silicium, la boue comprenant un liquide de suspension dans lequel des particules de dioxyde de manganèse sont mises en suspension, dans laquelle la boue possède un pH de 6,5 ou plus et un potentiel redox V qui rentre dans la plage spécifiée par la formule suivante représentant une relation entre la valeur V et le pH : 1,014 - 0,0591 pH $\leq$ V $\leq$ 1,620 - 0,0743 pH.

2. Procédé pour le polissage de carbure de silicium, le procédé comprenant l'utilisation d'une boue de polissage pour le polissage de carbure de silicium, la boue comprenant un liquide de suspension dans lequel des particules de dioxyde de manganèse sont mises en suspension, procédé dans lequel la boue possède un pH de 6,5 ou plus et un potentiel redox V qui rentre dans la plage spécifiée par la formule suivante représentant une relation entre la valeur V et le pH : 1,014 - 0,0591 pH $\leq$ V $\leq$ 1,620 - 0,0743 pH.

# Fig. 1

**Fig. 2**

**Fig. 3**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6159858 A
- EP 1717286 A1
- JP 2008166329 A
- JP 2009179726 A
- JP HEI1072578 B
- JP HEI1060415 B

### Non-patent literature cited in the description

- **MARCEL POURBAIX.** Atlas of Electrochemical Equilibria in Aqueous Solutions. Pergamon Press Cebelcor, 1996